# EUROPEAN PATENT SPECIFICATION

(11) **EP 3 762 973 B1**
(45) Date of publication and mention of the grant of the patent: **29.03.2023**
(21) Application number: 19710994.5
(22) Date of filing: 05.03.2019
(51) Int. Cl.: H01L 31/048

(54) **PHOTOVOLTAIC MODULE AND ENCAPSULANT COMPOSITION HAVING IMPROVED RESISTANCE TO POTENTIAL INDUCED DEGRADATION**
FOTOVOLTAISCHES MODUL UND EINKAPSELUNGSZUSAMMENSETZUNG MIT VERBESSERTER BESTÄNDIGKEIT GEGEN POTENTIELLE INDUZIERTE DEGRADATION
MODULE PHOTOVOLTAÏQUE ET COMPOSITION D'ENCAPSULATION PRÉSENTANT UNE RÉSISTANCE AMÉLIORÉE À LA DÉGRADATION INDUITE PAR UN POTENTIEL

(30) Priority: 08.03.2018 US 201862640073 P
(43) Date of publication of application: 13.01.2021
(73) Proprietor: Dow Global Technologies LLC, Midland, MI 48674 (US)
(72) Inventor: CHOU, Richard T., Hockessin, Delaware 19707 (US); KAPUR, Jane, Wilmington, Delaware 19805 (US)
(74) Representative: Boult Wade Tennant LLP
(86) International application number: PCT/US2019/020643
(87) International publication number: WO 2019/173262

(56) References cited:
- JP-A- 2017 188 577
- US-A1- 2015 000 739
- US-A1- 2015 311 370
- US-A1- 2015 325 729

## Description

### FIELD

Provided herein is an encapsulant composition for a photovoltaic module. The encapsulant composition comprises a copolymer of copolymerized ethylene and vinyl acetate and an enhancing ANTI-PID copolymer having the general structure E/X, where E is ethylene and X is half-ester of maleic anhydride, or an E/X/Y, where E is ethylene, X is half-ester of maleic anhydride, and Y is an alkyl acrylate. Further provided herein is a photovoltaic module comprising the encapsulant composition. The photovoltaic module is less susceptible to potential-induced degradation than are photovoltaic modules that use encapsulants that are primarily copolymers of ethylene and vinyl acetate.

### BACKGROUND

Several patents and publications are cited in this description in order to more fully describe the state of the art to which this invention pertains. The entire disclosure of each of these patents and publications is incorporated by reference herein.

Photovoltaic modules are an important source of renewable energy. In particular, they include solar cells that release electrons when exposed to sunlight. These solar cells, which are usually semiconductor materials that may be fragile, are typically encased or encapsulated in polymeric materials that protect them from physical shocks and scratches. The encased solar cells are generally further protected by glass or by another outer layer that is resistant to weathering, abrasion or other physical insults.

Ideally, the encapsulant, the glass layers and the other components in the photovoltaic module protect the solar cells and do not detract from the efficiency of the conversion of light to electricity. The phenomenon of potential-induced degradation ("PID"), however, is a known problem that causes solar cells to decrease or to cease producing electricity when a photovoltaic module operates at a large potential between its solar cells and another portion of the module, such as a frame. Therefore, one approach to the problem of PID is to design modules in which the solar cells are electrically insulated from the frames and other portions of the module, thereby preventing the development of these large internal potentials or "polarization." See, for example, U.S. Patent Application. Publication No. 20120266943, by Li. In another approach, U.S. Patent No. 7,554,031, issued to Swanson et al., describes providing conductive pathways between various portions of the photovoltaic module, so that harmful polarization is minimized or prevented.

US-A-2015/325729 relates to a photovoltaic module comprising an encapsulant layer and a solar cell assembly, said encapsulant layer comprising an encapsulant composition, and said encapsulant composition comprising a copolymer or an ionomer that is a neutralized product of the copolymer; wherein the copolymer comprises copolymerized residues of ethylene, copolymerized residues of vinyl acetate and copolymerized residues of a third comonomer, and wherein the third comonomer is selected from the group consisting of carbon monoxide, and α,β-ethylenically unsaturated carboxylic acid having from 3 to 8 carbon atoms, maleic anhydride and maleic anhydride mono-methyl ester (MAME). US 2015/000739 A1 discloses an encapsulant material comprising a blend of an EVA copolymer and an anti-PID copolymer comprising ethylene and an **α**-olefin.

Several different factors are believed to contribute to PID. For example, in U.S. Patent Application. Publication No. 2011/0048505, by Bunea et al., it is asserted that PID can be reduced or eliminated by operating the solar cells under exposure to an increased proportion of solar UV irradiation. Without wishing to be held to theory, however, the migration of water and ions to the surface of the solar cells appears to be the major mechanism of PID. Other factors affecting PID, such as the voltage at which the photovoltaic modules are operated and the design of the electrical circuits, are believed to be secondary in that they affect the magnitude or direction of the water and ion migration.

In particular, it is hypothesized that the diffused water and ions cause a detrimental electrochemical reaction that deactivates the p-n junctions of the solar cells. In this connection, in Intl. Patent Application. Publication No. WO2013/020128 by Aitken et al., it is asserted that PID can be reduced or eliminated by substituting glass that is free of or substantially free of alkali ions, such as sodium ions, for standard soda-lime glass in photovoltaic modules. The importance of selecting a chemically appropriate anti-reflective coating has been discussed in S. Pingel et al., "Potential Induced Degradation of Solar Cells and Panels," 35th IEEE PVSC, Honolulu, 2010, 2817-2822., for example. The rate of PID can be controlled by varying the Si-to-N ratio which is a function of the refractive index and thus corresponds to optical characteristics. In addition, U.S. Patent No. 8,188,363, issued to Xavier et al., asserts that PID can be eliminated by interposing an electrically insulating fluorocarbon layer between the glass and the solar cells. This fluorocarbon layer may also be a barrier to the migration of water or ions.

Furthermore, other important properties of photovoltaic modules are known to be affected adversely by elevated temperature and levels of moisture. These properties include, for example, mechanical integrity, electrical properties such as volume resistivity, current leakage, and overall cell efficiency.

Therefore, it is important to understand and control the factors that influence the rate and magnitude of moisture ingress and ion migration in encapsulants. An encapsulant that effectively prevents or reduces the movement of water and ions within a photovoltaic module will allow greater flexibility in the module's design and operating conditions. Moreover, this encapsulant will increase the module's efficiency and useful lifetime by reducing or preventing PID.

It is apparent from the foregoing that a need exists for polymeric materials that, when used as encapsulants in photovoltaic modules, prevent or reduce the potential-induced degradation of solar cells.

### SUMMARY

Accordingly, in a first embodiment provided herein is an encapsulant composition for a photovoltaic module. The encapsulant composition including a copolymer of copolymerized ethylene and vinyl acetate (EVA) and an enhancing ANTI-PID copolymer A. The enhancing ANTI-PID copolymer A is an E/X, where E is ethylene and X is half-ester of maleic anhydride, or an E/X/Y, where E is ethylene, X is half-ester of maleic anhydride, and Y is an alkyl acrylate.

Further provided herein is a photovoltaic module including the encapsulant composition. The photovoltaic module is less susceptible to potential-induced degradation than are photovoltaic modules that use encapsulants that are primarily copolymers of ethylene and vinyl acetate.

In another embodiment, the invention is directed to a method of reducing the potential-induced degradation of a photovoltaic module including the steps of providing a solar cell assembly, a glass layer, and an encapsulant layer. The encapsulant layer having an encapsulant composition including a copolymer of copolymerized ethylene and vinyl acetate and an enhancing ANTI-PID copolymer. The enhancing ANTI-PID copolymer A is an E/X, where E is ethylene and X is half-ester of maleic anhydride, or an E/X/Y, where E is ethylene, X is half-ester of maleic anhydride, and Y is an alkyl acrylate. Fabricating a photovoltaic module having the structure of glass layer/encapsulant layer/solar cell/encapsulant layer/backsheet assembly and operating the photovoltaic module. Thereafter, observing the current generated by the photovoltaic module as a function of time.

### DETAILED DESCRIPTION

The following definitions are used herein to further define and describe the disclosure. These definitions apply to the terms as used throughout this specification, unless otherwise limited in specific instances.

Unless otherwise defined, all technical and scientific terms used herein have the same meaning as commonly understood by one of ordinary skill in the art to which this invention belongs. In case of conflict, the present specification, including the definitions set forth herein, will control.

Unless explicitly stated otherwise in defined circumstances, all percentages, parts, ratios, and like amounts used herein are defined by weight.

When materials, methods, or machinery are described herein with the term "known to those of skill in the art", "conventional" or a synonymous word or phrase, the term signifies that materials, methods, and machinery that are conventional at the time of filing the present application are encompassed by this description. Also encompassed are materials, methods, and machinery that are not presently conventional, but that will have become recognized in the art as suitable for a similar purpose.

As used herein, the terms "comprises," "comprising," "includes," "including," "containing," "characterized by," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus.

The transitional phrase "consisting of" excludes any element, step, or ingredient not specified in the claim, closing the claim to the inclusion of materials other than those recited except for impurities ordinarily associated therewith. When the phrase "consists of" appears in a clause of the body of a claim, rather than immediately following the preamble, it limits only the element set forth in that clause; other elements are not excluded from the claim as a whole.

The transitional phrase "consisting essentially of" limits the scope of a claim to the specified materials or steps and those that do not materially affect the basic and novel characteristic(s) of the claimed invention. A 'consisting essentially of claim occupies a middle ground between closed claims that are written in a 'consisting of format and fully open claims that are drafted in a 'comprising' format. Optional additives as defined herein, at levels that are appropriate for such additives, and minor impurities are not excluded from a composition by the term "consisting essentially of".

When a composition, a process, a structure, or a portion of a composition, a process, or a structure, is described herein using an open-ended term such as "comprising," unless otherwise stated the description also includes an embodiment that "consists essentially of" or "consists of' the elements of the composition, the process, the structure, or the portion of the composition, the process, or the structure.

Further in this connection, certain features of the invention which are, for clarity, described herein in the context of separate embodiments, may also be provided in combination in a single embodiment. Conversely, various features of the invention that are, for brevity, described in the context of a single embodiment, may also be provided separately or in any sub-combination.

The articles "a" and "an" may be employed in connection with various elements and components of compositions, processes or structures described herein. This is merely for convenience and to give a general sense of the compositions, processes or structures. Such a description includes "one or at least one" of the elements or components. Moreover, as used herein, the singular articles also include a description of a plurality of elements or components, unless it is apparent from a specific context that the plural is excluded.

Further, unless expressly stated to the contrary, the conjunction "or" refers to an inclusive or and not to an exclusive or. For example, the condition "A or B" is satisfied by any one of the following: A is true (or present) and B is false (or not present), A is false (or not present) and B is true (or present), and both A and B are true (or present). Exclusive "or" is designated herein by terms such as "either A or B" and "one of A or B", for example.

The term "about" means that amounts, sizes, formulations, parameters, and other quantities and characteristics are not and need not be exact, but may be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such.

In addition, the ranges set forth herein include their endpoints unless expressly stated otherwise. Further, when an amount, concentration, or other value or parameter is given as a range, one or more preferred ranges or a list of upper preferable values and lower preferable values, this is to be understood as specifically disclosing all ranges formed from any pair of any upper range limit or preferred value and any lower range limit or preferred value, regardless of whether such pairs are separately disclosed. The scope of the invention is not limited to the specific values recited when defining a range.

The term "alkyl", as used herein alone or in combined form, such as, for example, "alkyl group" or "alkoxy group", refers to saturated hydrocarbon groups that have from 1 to 8 carbon atoms having one substituent and that may be branched or unbranched.

As used herein, the term "copolymer" refers to polymers comprising copolymerized units resulting from copolymerization of two or more comonomers. In this connection, a copolymer may be described herein with reference to its constituent comonomers or to the amounts of its constituent comonomers, for example "a copolymer comprising ethylene and 18 weight % of vinyl acetate", or a similar description. Such a description may be considered informal in that it does not refer to the comonomers as copolymerized units; in that it does not include a conventional nomenclature for the copolymer, for example International Union of Pure and Applied Chemistry (IUPAC) nomenclature; in that it does not use product-by-process terminology; or for another reason. As used herein, however, a description of a copolymer with reference to its constituent comonomers or to the amounts of its constituent comonomers means that the copolymer contains copolymerized units (in the specified amounts when specified) of the specified comonomers. It follows as a corollary that a copolymer is not the product of a reaction mixture containing given comonomers in given amounts, unless expressly stated in limited circumstances to be such. The term "copolymer" may refer to polymers that consist essentially of copolymerized units of two different monomers (a dipolymer), or that consist essentially of more than two different monomers (a terpolymer consisting essentially of three different comonomers, a tetrapolymer consisting essentially of four different comonomers, etc.).

The term "laminate", as used herein alone or in combined form, such as "laminated" or "lamination" for example, refers to a structure having at least two layers that are adhered or bonded firmly to each other, optionally using heat and/or vacuum and/or positive pressure. The layers may be adhered to each other directly or indirectly. In this context, the term "directly" means that there is no additional material, such as an interlayer, an encapsulant layer or an adhesive layer, between the two layers, and the term "indirectly" means that there is additional material between the two layers.

In a first embodiment, the invention is directed to an encapsulant composition for a photovoltaic module. The encapsulant composition includes a copolymer of copolymerized ethylene and vinyl acetate and an enhancing ANTI-PID copolymer A, where the enhancing ANTI-PID copolymer is an E/X, where E is ethylene and X is half-ester of maleic anhydride, or an E/X/Y, where E is ethylene, X is half-ester of maleic anhydride, and Y is an alkyl acrylate. Further provided herein is a photovoltaic module comprising the encapsulant composition. The photovoltaic module is less susceptible to potential-induced degradation than are photovoltaic modules that use encapsulants that are primarily copolymers of ethylene and vinyl acetate.

Photovoltaic modules comprising a layer of the encapsulant composition described herein comprising an ANTI-PID enhancing copolymer A are resistant to potential-induced degradation (PID). Without wishing to be held to theory, it is believed that the encapsulant composition has a low permeability of ions, such as alkali metal cations and, in particular, sodium cations. Therefore, the ions are prevented from reaching the surface of the solar cell, where they would cause PID to occur.

The ANTI-PID enhancing copolymer A is in the range of 1-30 wt.% of the total weight of EVA and Copolymer A, preferentially in the range of 2-20 wt.%, and most preferentially in the range of 4-15 wt.%.

The EVA of the encapsulant composition is a copolymerized ethylene and vinyl acetate, where vinyl acetate is in the range of 15 wt% to about 35 wt% of the polymer weight, most preferably 25-32 wt.%, with a melt flow rate of 0.5 to 100 g/10 min, as determined in accordance with ASTM D1238 at 190°C and 2.16 kg.

The ANTI-PID copolymer A which serves as the modifier for enhancing the ANTI-PID performance is an E/X copolymer, where X is half-ester of maleic anhydride. The E/X copolymer includes maleic anhydride mono-methyl ester, maleic anhydride mono-ethyl ester (MAME), maleic anhydride mono-propyl ester, maleic anhydride mono-butyl ester or a combination of those, in the range of 12 to 25 wt.% of the polymer weight, most preferably 15-20 wt.%.

In a variation of the current embodiment, copolymer A is an E/X/Y copolymer, wherein X is maleic anhydride mono-methyl ester, maleic anhydride mono-ethyl ester (MAME), maleic anhydride mono-propyl ester propyl, maleic anhydride mono-butyl ester or a combination of those, in the range of 6 to 20 wt.% of the polymer weight, most preferably 8-15 wt.%; and Y is methyl acrylate, ethyl acrylate, n-butyl acrylate or iso-butyl acrylate, in the range of 1 to 30 wt.%, the polymer weight, most preferably 5-15 wt.%.

The Photovoltaic modules containing the encapsulant composition of the present embodiment passes 1000-1500 voltage at such condition according to the International Electrotechnical Commission method: IEC TS 62804-1 technical specification.

Suitable ANTI-PID copolymer A should have physical properties that are fit for use in the encapsulant composition. In particular, the encapsulant composition desirably has an appropriate toughness and resilience, to cushion the solar cells and other electrical components of the photovoltaic module from physical shock. Also desirably, the encapsulant composition is easily processible, for example, capable of formation into sheets and capable of lamination under standard conditions. Further desirably, the encapsulant composition has suitable optical properties, such as transparency to solar radiation when used on the light-incident side of a photovoltaic module.

The encapsulant composition may add another polymer B or more, different from the EVA and the copolymer A, in the range of 0-20 wt.% of the combination of EVA and copolymer A, provided that the polymer B does not hinder the ANTI-PID performance and reduce the PV performance. Polymer B can be a polyolefin or an ethylene copolymer other than the EVA and the copolymer A employed in the encapsulant composition. One skilled in the art would recognize the addition of these additional polymers are within the scope of the present invention.

The encapsulant composition may also contain additives for effecting and controlling cross-linking such as organic peroxides, inhibitors and initiators. Suitable examples of cross-linking additives and levels of these additives are set forth in detail in U.S. Patent No. 6,093,757, issued to F.-J. Pern, in U.S. Patent Publication Nos. 2012/0168982, by J.W. Cho et al., and 2012/0301991, by S. Devisme et al., and in Holley, W.W., and Agro, S.C. "Advanced EVA-Based Encapsulants - Final Report January 1993-June 1997", NREL/SR-520-25296,Sept. 1998, Appendix D.

In addition, four particularly useful additives for use in the encapsulant compositions are thermal stabilizers, UV absorbers, hindered amine light stabilizers (HALS), and silane coupling agents. Suitable examples of the four additives and levels of these additives are set forth in detail in U.S. Patent No. 8,399,096, issued to Hausmann, et al.

The encapsulant composition may also include one or more other additives suitable other additives may include, but are not limited to, plasticizers, processing aides, flow enhancing additives, lubricants, pigments, dyes, flame retardants, impact modifiers, nucleating agents, anti-blocking agents (e.g., silica), dispersants, surfactants, chelating agents, coupling agents, adhesives, primers, reinforcement additives (e.g., glass fiber), other fillers, and the like. Suitable other additives, additive levels, and methods of incorporating the additives into the copolymer compositions may be found in the Kirk-Othmer Encyclopedia of Chemical Technology, 5th Edition, John Wiley & Sons (New Jersey, 2004). In general, the total amount of these other additives, if present, is less than 5 wt%, less than 3 wt%, less than 2 wt%, or less than 1 wt%, based on the total weight of the encapsulant composition.

The encapsulant composition may be made by any suitable process, such as melt mixing in an extruder with high-shear melt-mixing is preferred. Suitable high shear mixing equipment includes static mixers, rubber mills, Brabender mixers, Buss kneaders, single screw extruders, twin screw extruders, heated or unheated two-roll mills, and the like. Additional examples of suitable compounding processes and conditions may also be found in the Kirk-Othmer Encyclopedia and the Modern Plastics Encyclopedia, McGraw-Hill (New York, 1995).

The encapsulant composition may be formed into films or sheets by any suitable process. Information about these processes may be found in reference texts such as, for example, the Kirk Othmer Encyclopedia*,* the Modern Plastics Encyclopedia or the Wiley Encyclopedia of Packaging Technology, 2d edition, A.L. Brody and K.S. Marsh, Eds., Wiley-Interscience (Hoboken, 1997). For example, the sheets may be formed through dipcoating, solution casting, compression molding, injection molding, lamination, melt extrusion, blown film, extrusion coating, tandem extrusion coating, or any other suitable procedure. Preferably, the sheets are formed by a melt extrusion, melt coextrusion, melt extrusion coating, or tandem melt extrusion coating process.

In this connection, the terms "film" and "sheet", as used herein, refer to substantially planar, continuous articles. The term "continuous", as used in this context, means that the film or sheet has a length of at least about 3 m, at least about 10 m, at least about 50 m, at least about 100 m, or at least about 250 m. Moreover, the sheeting has an aspect ratio, that is, a ratio of length to width, of at least 5, at least 10, at least 25, at least 50, at least 75 or at least 100.

Moreover, the difference between a film and a sheet is the thickness; however, there is no industry standard for the precise thickness that distinguishes between a film and a sheet. As used herein, however, a film generally has a thickness of about 10 mils (0.254 mm), or less. A sheet generally has a thickness of greater than about 10 mils (0.254 mm). The descriptions herein pertain equally to films and to sheets, unless otherwise limited in specific instances. For convenience, however, only one of these terms may be used in a given context.

In addition, the sheets comprising the encapsulant composition may have a smooth or rough surface on one or both sides. Preferably, the sheets have rough surfaces on both sides to facilitate the deaeration during the lamination process. Rough surfaces may be produced by conventional processes such as mechanical embossing. For example, the as-extruded sheet may be passed over a specially prepared surface of a die roll positioned in close proximity to the exit of the die. This die roll imparts the desired surface characteristics to one side of the molten polymer. Thus, when the surface of such a textured roll has minute peaks and valleys, the still-impressionable polymer sheet cast on the textured roll will have a rough surface on the side that is in contact with the roll. The rough surface generally conforms respectively to the valleys and peaks of the roll surface. Textured rolls are described in, e.g., U.S. Patent No. 4,035,549 and U.S. Patent Application Publication No. 2003/0124296.

Photovoltaic modules comprising a layer of the encapsulant composition described herein are resistant to potential-induced degradation (PID). Without wishing to be held to theory, it is believed that the encapsulant composition has a low permeability of ions, such as alkali metal cations and in particular sodium cations. Therefore, the ions are prevented from reaching the surface of the solar cell, where they may cause damage to the solar cell.

Accordingly, further provided herein are photovoltaic modules comprising the encapsulant composition. Structures of photovoltaic modules that may suitably include the encapsulant composition include, without limitation, the structures that are described in detail in U.S. Patent No. 8,399,081, issued to Hayes et al. A layer of the encapsulant composition may be substituted for any polymeric layer described by Hayes et al. Preferably, a layer of the encapsulant composition described herein is substituted for any encapsulant layer described by Hayes et al., including front or sun-facing encapsulant layers and back or non-sun-facing encapsulant layers. More preferably, a layer of the encapsulant composition described herein is substituted for an encapsulant layer that is disposed between the solar cells and a sheet of sodium ion-containing glass. Still more preferably, a layer of the encapsulant composition described herein is substituted for an encapsulant layer that is disposed between the solar cells and a sheet of sodium ion-containing glass on the front or sun-facing side of the photovoltaic module.

Also, a layer of the encapsulant composition described herein is used in conjunction with any encapsulant layer described by Hayes et al. More specifically, a preferred photovoltaic module has the structure glass/first encapsulant layer layer/solar cell assembly/second encapsulant layer/flexible backsheet or glass, in which one of the first or second encapsulant layers comprises the EVA and the E/X copolymer A described herein and the other of the first or second encapsulant layers may be any encapsulant layer described by Hayes et al. In this preferred photovoltaic module, the first and second encapsulant layers may be front or back encapsulant layers. Moreover, any photovoltaic module comprising an encapsulant layer that is disposed between the solar cell assembly and a sheet of sodium ion-containing glass is a preferred photovoltaic module, when the so-disposed encapsulant layer is substituted with a first and a second encapsulant layer in which one of the first or second encapsulant layers comprises the EVA and the E/X copolymer A described herein and the other of the first or second encapsulant layers may be any encapsulant layer described by Hayes et al.

Photovoltaic modules also comprise solar cell assemblies. These assemblies comprise one or more solar cells. The two most common types of photovoltaic modules include wafer-based solar cells or thin film solar cells. Photovoltaic modules that include wafer-based solar cells generally have a structure that includes the following layers: glass/encapsulant/solar cell(s)/encapsulant/glass or glass/encapsulant/solar cell(s)/encapsulant/flexible backsheet.

Thin film solar cells are an alternative to wafer-based solar cells. The materials commonly used for such cells include amorphous silicon (a-Si), microcrystalline silicon (µc-Si), cadmium telluride (CdTe), copper indium selenide (CuInSe₂ or CIS), copper indium/gallium diselenide (CuInₓGa₍₁₋ₓ₎Se₂ or CIGS), light absorbing dyes, organic semiconductors, and the like. By way of example, thin film solar cells are described in U.S. Patent Nos. 5,507,881; 5,512,107; 5,948,176; 5,994,163; 6,040,521; 6, 123,824; 6,137,048; 6,288,325; 6,258,620; 6,613,603; and 6,784,301; and U.S. Patent Publication Nos. 20070298590; 20070281090; 20070240759; 20070232057; 20070238285; 20070227578; 20070209699; 20070079866; 20080223436; and 20080271675, for example.

A thin film solar cell assembly typically comprises a substrate. Multiple layers of light absorbing and semiconductor materials are deposited on the substrate. The substrate may be glass or a flexible film. The substrate may also be referred to as a superstrate in those modules in which it faces toward the incoming sunlight. The thin film solar cell assemblies may further comprise conductive coatings, such as transparent conductive oxides (TCO) or electrical wirings, which are generally deposited on the semiconductor materials. Similar to the wafer-based solar cell assemblies, the thin film solar cell assembly may be sandwiched or laminated between polymeric encapsulant layers, and this structure in turn may be sandwiched or laminated between outer protective layers.

The thin film solar cell assembly may have only one surface, specifically the surface opposite from the substrate or superstrate, that is laminated to a polymeric encapsulant layer. In these solar cell modules, the encapsulant layer is most often in contact with and laminated to an outer protective layer. For example, the thin film solar cell module may have a lamination structure comprising, in order of position from the front or sun-facing side to the back or non-sun-facing side, (1) a thin film solar cell assembly having a superstrate on its front sun-facing side, (2) a polymeric back encapsulant layer, and (3) a back protective layer or "back sheet." In this structure, the superstrate performs the functions of the front protective layer.

Alternatively, the thin film solar cell module may have a laminated structure comprising, in order of position from the front or sun-facing side to the back or non-sun-facing side, (1) a front protective layer or "front sheet," (2) a polymeric front encapsulant sheet, and (3) a thin film solar cell assembly having a substrate on its back or non-sun-facing side. In this structure, the substrate also performs the functions of the back protective layer.

Suitable plastic film layers used for backsheets include, without limitation, polymers such as polyesters (e.g., poly(ethylene terephthalate) and poly(ethylene naphthalate)), polycarbonates, polyolefins (e.g., polypropylene, polyethylene, and cyclic polyolefins), norbornene polymers, polystyrenes (e.g., syndiotactic polystyrene), styrene-acrylate copolymers, acrylonitrile-styrene copolymers, polysulfones (e.g., polyethersulfone, polysulfone, etc.), nylons, poly(urethanes), acrylics, cellulose acetates (e.g., cellulose acetate, cellulose triacetate, etc.), cellophanes, poly(vinyl chlorides) (e.g., poly(vinylidene chloride)), fluoropolymers (e.g., polyvinyl fluoride, polyvinylidene fluoride, polytetrafluoroethylene, ethylene-tetrafluoroethylene copolymers and the like) and combinations of two or more thereof. The plastic film may also be a bi-axially oriented polyester film (preferably poly(ethylene terephthalate) film) or a fluoropolymer film (e.g., Tedlar^{®}, Tefzel^{®}, and Teflon^{®} films, from E. I. du Pont de Nemours and Company, Wilmington, DE (DuPont)). Further the films used herein may be in the form of a multilayer film, such as a fluoropolymer/polyester/ fluoropolymer multilayer film (e.g., Tedlar^{®}/PET/Tedlar^{®} or TPT laminate film available from Isovolta AG., Austria or Madico, Woburn, MA). These same materials, when transparent, are also suitable for use in flexible frontsheets.

The term "glass", as used herein, includes window glass, plate glass, silicate glass, sheet glass, low iron glass, tempered glass, tempered low iron glass, tempered CeO-free glass, float glass, colored glass, specialty glass (such as those containing ingredients to control solar heating), coated glass (such as those sputtered with metal compounds (e.g., silver or indium tin oxide) for solar control purposes), low E-glass, Toroglas^{™} glass (Saint-Gobain N.A. Inc., Trumbauersville, PA), Solexia^{™} glass (PPG Industries, Pittsburgh, PA) and Starphire^{™} glass (PPG Industries). These and other specialty glasses are described in U.S. Patent Nos. 4,615,989; 5,173,212; 5,264,286; 6,150,028; 6,340,646; 6,461,736; and 6,468,934, for example.

Other materials, such as polymeric films, may be substituted for one or more of the glass layers in both types of photovoltaic module. The photovoltaic modules of the invention, however, preferably include at least one layer of glass. When the encapsulant composition described herein is used in an encapsulant layer, these photovoltaic modules provide significantly greater stability with respect to PID, when compared to photovoltaic modules that include conventional EVA encapsulants. The improvement in stability is greater in photovoltaic modules in which the photovoltaic module comprises glass. Preferably, the glass is not a low sodium or low alkali glass, such as the glasses described in Intl. Patent Appln. Publn. No. WO2013/020128.

When the photovoltaic module comprises more than one encapsulant layer, the additional encapsulant layer(s) may comprise the encapsulant composition as described herein. Alternatively, the additional encapsulant layer(s) may comprise other polymeric materials, such as acid copolymers, ionomers of acid copolymers, ethylene/vinyl acetate copolymers, poly(vinyl acetals) (including acoustic grade poly(vinyl acetals)), polyurethanes, poly(vinyl chlorides), polyethylenes (e.g., linear low density polyethylenes), polyolefin block copolymer elastomers, copolymers of α-olefins and α,β-ethylenically unsaturated carboxylic acid esters) (e.g., ethylene methyl acrylate copolymers and ethylene butyl acrylate copolymers), silicone elastomers, epoxy resins, any encapsulant layer described by Hayes et al., and combinations of two or more of these materials.

Each encapsulant layer in the photovoltaic module has a thickness that may independently range from about 5 to about 40 mils (about 0.125 to about 1 mm), or about 2 to about 30 mils (about 0.250 to about 0.625 mm), or about 15 to about 20 mils (about 0.381 to about 0.505 mm). When the encapsulant layer is in multilayer form, the total thickness of the multilayer encapsulant falls within the ranges set forth above. Additionally, the photovoltaic modules described herein may have more than one encapsulant layer, for example a front encapsulant layer (in front of the solar cell) and a back encapsulant layer (behind the solar cell). Each of these encapsulant layers has a total thickness as set forth above.

Photovoltaic modules comprising the encapsulant composition may be made by any suitable process. Photovoltaic modules are most often made by vacuum lamination processes, such as those described in U.S. Pat. No. 5,593,532. Alternatively, photovoltaic modules may be made by autoclave lamination processes, such as those described with respect to glass laminates in U.S. Patent No. 7,763,360 and in U.S. Patent Publication No. 2007/0228341. Non-autoclave lamination processes may also be used, however. Some examples of suitable non-autoclave lamination processes are also described in U.S. Patent Nos. 7,763,360 and 8,637,150.

It is believed that one of ordinary skill in the art will be able to make any adjustments to the lamination process that may be required. For example, if the melt index of the encapsulant composition described herein is increased relative to that of a conventional encapsulant layer, reasonable adjustments to the process include decreasing the lamination temperature or the cycle time.

The following examples are provided to describe the invention in further detail. These examples, which set forth specific embodiments and a preferred mode presently contemplated for carrying out the invention, are intended to illustrate and not to limit the invention.

### EXAMPLES

### Materials and methods

The following materials were used throughout the Examples listed in Table 1, 2 & 3, unless otherwise specified:
- Annealed Float Glass - AGC Solite 145 × 155 × 3.2 mm, AGC Flat Glass North America, Alpharetta, GA
- Back Sheets - Dun-Solar 1200TPT, Dunmore Corp., Bristol, PA
- Solar Cells - Motech monocrystalline XS125-165R, Motech Industries, Tainan City, Taiwan
- Wires, tabbing ribbon, busbars - Wuxi Sveck Technology, Wuxi, China
   ∘ Composition - 62% tin, 36% lead, 2% silver
   ∘ Tabbing ribbon - 0.16 × 2 mm
   ∘ Busbars - 0.2 × 5 mm
- Junction Box - Renhe Solar, Model No. PV-RH06-60, Renhe Solar, Zhejiang, China
- Encapsulants (used as shown in Table 1 and Table 2)
   ∘ STR15420P, a commercial EVA encapsulant, from STR Holdings, Enfield, CT
   ∘ HZ 406P, a commercial EVA encapsulant from Hangzhou First Applied Materials, Hangzhou, China
   ∘ EN1 to EN4 containing EVA and E/MAME as follows:
      EVA - an ethylene/vinyl acetate copolymer comprising 28 wt% of copolymerized units of vinyl acetate, based on the total weight of the copolymer, and having a melt flow rate of 3.0 g/10 min, as determined in accordance with ASTM D1238 at 190°C and 2.16 kg;
      E/MAME - an ethylene/monoethyl maleate copolymer comprising 15 wt% of copolymerized units of the monoethyl ester of maleic acid, based on the total weight of the copolymer, and having a melt flow rate of 400 g/10 min, as determined in accordance with ASTM D1238 at 190°C and 2.16 kg;

The specific formulation for E/MAME containing encapsulants EN1-EN4 are given in Table 1. The Crosslinking agent is tert-Butylperoxy 2-ethylhexyl carbonate (TBEC) (Luperox^{®} TBEC, Arkema). The crosslinking co-agent, triallyl isocyanurate (TAIC, Ciba). The light stabilizer is bis(2,2,6,6,-tetramethyl-4-piperidyl) sebaceate (Tinuvin 770, Ciba). The silane coupling agent is 3-Methacryloxypropyl trimethoxysilane (KBM-503, Shin-Etsu Chemical) The UV absorber is [2-hydroxy-4-(octyloxy)phenyl]phenyl Methanone (Chimassorb 81, Ciba). All additives were used without further purification and the additive formulation is based on 100 parts of the EVA and EMAME copolymer blend.

The EN1 to EN4 cast sheets used as encapsulant in Table 2 and Table 3 were prepared as follows. The EVA was soaked with the silane coupling agent overnight for a minimum of eight hours. A concentrate containing the rest of the additives, i.e., the crosslinking agent, the crosslinking co-agent, the light stabilizer and the UV absorber, is made with the EVA resin to increase the uniformity of the final formulated compound. The silane soaked EVA, the concentrate, and EMAME resin are mixed uniformly and fed into the hopper of a twin-screw extruder with set temperatures less than 110C to prevent premature crosslinking of the resin matrix.

**Table 1. Encapsulant Formulation of EVA with EMAME**

| | EN 1 | EN 2 | EN 3 | EN 4 |
|---|---|---|---|---|
| EVA copolymer | 95 | 90 | 85 | 80 |
| EMAME copolymer | 5 | 10 | 15 | 20 |
| Luprerox^{®} TBEC | 0.5 | 0.5 | 0.5 | 0.5 |
| TAIC | 0.5 | 0.5 | 0.5 | 0.5 |
| Tinuvin^{®} 770 | 0.1 | 0.1 | 0.1 | 0.1 |
| KBM-503 | 0.175 | 0.175 | 0.175 | 0.175 |
| Chimassorb^{®} 81 | 0.05 | 0.05 | 0.05 | 0.05 |

The photovoltaic modules of Table 2 and Table 3 were formed by lamination according to the following method. Annealed float glass (AGC Solite 145x155x3.2mm, AGC Flat Glass North America, Alpharetta, GA) was rinsed with de-ionized water and dried. The following module construction was made: glass/front encapsulant/one solar cell/back encapsulant/backsheet. The front encapsulants and the back encapsulants that were used are described in the Examples in Table 2 and Table 3. The solar cells (XS125-165R, Motech Industries, Inc., Tainan City, Taiwan) were mono-crystalline and tabbed with 0.16 × 2mm ribbon (Wuxi Sveck Technology, Wuxi, China). The 0.2 × 5mm busbars (Wuxi Sveck Technology, Wuxi, China) were electrically isolated with the Dunsolar 1200TPT backsheet (Dunmore Corporation, Bristol, PA).

The vacuum-lamination cycle was at set temperature of 150°C with an 18 minute processing time in which the vacuum time was 4 minutes and the press time was 13 minutes at a constant pressure of 1000 mbar. The vacuum laminator was a Meier Icolam Model 2515 (NPC-Meier GMBH, Bocholt, Germany). The mini-module was removed from the vacuum laminator and allowed to cool to ambient temperature. The busbars were soldered to the junction box, which was attached to the module with a sealant.

Photovoltaic modules were tested for PID according to the following method. The modules were taped on all four edges of the cover glass with 3M 1-inch aluminum-based tape (3M Company, Saint Paul, MN). The front surface of the modules was completely covered with untreated aluminum foil. The aluminum-foiled modules were held at 60C and 85% relative humidity in an environmental chamber (Model SE-3000-4, Thermotron Industries, Holland, MI) for 96 hours while a voltage potential of -1kV was applied between the aluminum foil and the solar cells for 96 hours according the Technical Specification, IEC TS 62804-1.

After the test period of 96h, the modules were monitored by power measurements. The power output of the modules was measured with a Spire SPI-SUN Simulator 4600SLP (Spire Group LLC, Ridgefield, CT) with an AMI 1.5 light source according to IEC 16215 method.

The solar modules made with commercially available EVA based encapsulants in Comparative Examples CE1 and CE2 lost 90% and 78%, respectively, of their module's power. Thus, the potential of one kilovolt or 1000V degrades the power significantly, resulting in PID on these two modules in CE1 and CE2. The solar modules made with encapsulants comprised of EMAME and EVA copolymers in Examples EX1 (the encapsulant containing 5wt% EMAME), EX2 (the encapsulant containing 10wt% EMAME), EX3 (the encapsulant containing 15wt% EMAME) and EX4 (the encapsulant containing 20wt% EMAME) all lost less than 5% of their initial power or retained more than 95% of their initial power. Thus, the presence of EMAME, even at 5 wt.% in Example EX1, significantly improves the power retention and significantly reduces the effect of PID.

**Table 2. PID conditions: 60C/85%RH/-1000V (With Aluminum Foil)**

| Example | Front Encapsulant | Back Encapsulant | Power Retention after 96h at 60C/85%RH/- 1kV |
|---|---|---|---|
| CE1 | EVA (STR 15420) | EVA (STR 15420) | 9.9% |
| CE2 | EVA (HZ First 406P) | EVA (STR15420) | 21.8% |
| EX1 | EN1 | EN1 | 96.3% |
| EX2 | EN2 | EN2 | 97.4% |
| EX3 | EN3 | EN3 | 98.8% |
| EX4 | EN4 | EN4 | 98.0% |

Table 3 lists another set of photovoltaic modules and summarizes the power retained after module exposure to -1500V and 85 °C/85% relative humidity (RH). These modules were mounted with aluminum frames and no aluminum foil was used at this higher voltage potential. Thus, the glass of the module was exposed to 85%RH. Comparative Examples CE3 to CE4 had commercial EVA encapsulants, STR Solar 15420P and Hangzhou First 406P, respectively. Examples EX5 to EX8 had EVA and E/MAME based encapsulants, EN1 to EN4. The power retaining results of 1500V and 85°C/85%RH testing at 48 and 96 hours in demonstrate that photovoltaic modules having 5 to 20% EMAME containing encapsulants EN1 to EN4 all exhibited less than 5% reduction in PID, i.e., retained power above 95% over the test period. In contrast, photovoltaic modules having conventional EVA encapsulants in Comparative Examples CE3 and CE4, respectively, lost 30% and 65% of the modules' initial power by PID within 96 hours under the test conditions.

**Table 3. PID conditions: 85 °C/85%RH/-1500V (Without Aluminum Foil)**

| | | Percent Power Retained in mini-module | |
|---|---|---|---|
| Example | Front and back Encapsulant | 48h | 96h |
| CE3 | STR15420P EVA | 79.2% | 69.9% |
| CE4 | HZ 406P EVA | 49.9% | 35.4% |
| EX5 | EN1 | 97.3% | 95.0% |
| EX6 | EN2 | 99.1% | 97.1% |
| EX 7 | EN3 | 98.1% | 98.5% |
| EX 8 | EN4 | 97.9% | 96.9% |

While certain of the preferred embodiments of this invention have been described and specifically exemplified above, it is not intended that the invention be limited to such embodiments. Various modifications may be made without departing from the scope of the invention, as set forth in the following claims.

## Claims

1. A photovoltaic module comprising an encapsulant layer and a solar cell assembly, said encapsulant layer comprising an encapsulant composition, comprising a blend of a copolymer of ethylene and vinyl acetate (EVA) and an anti-potential-induced degradation (PID) enhancing copolymer A, **characterized in that** the encapsulant composition provides power output stability above >90% of the initial power output after an exposure to damp heat (85 °C/85%RH) and voltage potential of 1500V for up to 96 hours,
wherein the copolymer A is an E/X copolymer, wherein E is ethylene and X is half-ester of maleic anhydride and the E/X copolymer includes maleic anhydride mono-methyl ester, maleic anhydride mono-ethyl ester (MAME), maleic anhydride mono-propyl ester, maleic anhydride mono-butyl ester or a combination of those, in the range of 12 to 25 wt.% of the polymer weight;
or wherein the copolymer A is an E/X/Y copolymer, where E is ethylene, X is half-ester of maleic anhydride and X is maleic anhydride mono-methyl ester, maleic anhydride mono-ethyl ester (MAME), maleic anhydride mono-propyl ester, maleic anhydride mono-butyl ester or a combination of those, in the range of 6 to 20 wt.% of the polymer weight, and Y is methyl acrylate, ethyl acrylate, n-butyl acrylate or iso-butyl acrylate, or a mixture of those in the range of 1 to 30 wt.%,of the polymer weight.

2. The photovoltaic module of claim 1, wherein copolymer A is in the range of 1-30 wt.% of the total weight of EVA and Copolymer A, preferentially in the range of 2-20 wt.%, and most preferentially in the range of 4-15 wt.%.

3. A method of reducing the potential-induced degradation (PID) of a photovoltaic module, said method comprising the steps of providing a solar cell assembly, a glass layer, and an encapsulant layer comprising the encapsulant composition of claim 1; fabricating a photovoltaic module comprising the structure glass layer/encapsulant layer/solar cell assembly; operating the photovoltaic module; and observing the current generated by the photovoltaic module as a function of time.

4. The photovoltaic module of claim 1, wherein the encapsulant composition passes 1000 voltage potential at such condition according to the IEC TS 62804-1 technical specification.

5. The photovoltaic module of claim 1, wherein the encapsulant composition passes 1500 voltage potential at such condition according to the IEC TS 62804-1 technical specification.

6. The photovoltaic module of claim 1, wherein the copolymer of the encapsulant composition is a copolymerized ethylene and vinyl acetate, where vinyl acetate is in the range of 15 wt% to about 35 wt% of the polymer weight, most preferably 25-32 wt.%.

7. The photovoltaic module of claim 1, wherein the copolymer A is the E/X copolymer.

8. The photovoltaic module of claim 1, wherein the copolymer A is the E/X copolymer, and X is present in the range of 15-20 wt.% of the polymer weight.

9. The photovoltaic module of claim 1, wherein copolymer A is the E/X/Y copolymer.

10. The photovoltaic module of claim 1, wherein the copolymer A is the E/X/Y copolymer and X is present in the range of y 8-15 wt.% of the polymer weight; and wherein Y is present in the range of 5-15 wt.% of the polymer weight.

11. The photovoltaic module of claim 1, wherein the encapsulant composition comprises one or more other polymers, and or other additives, provided that those do not incur an adverse effect on the performance of the photovoltaic module.

12. The photovoltaic module of claim 1, further comprising one or more glass layers, one or more flexible back sheet layers, or a second encapsulant layer that may be the same as or different from the encapsulant layer.

13. The photovoltaic module of claim 1, consisting of a structure selected from the group of: glass/encapsulant/solar cell assembly/encapsulant layer/glass; glass/encapsulant/solar cell assembly/encapsulant/flexible backsheet; glass/encapsulant/solar cell assembly/glass; and glass/encapsulant/solar cell assembly/flexible backsheet.

14. The photovoltaic module of claim 1, wherein the solar cell assembly comprises a thin film solar cell.

15. The photovoltaic module of claim 1, wherein the encapsulant layer is in multilayer form.

## Patentansprüche

1. Fotovoltaikmodul, umfassend eine Verkapselungsschicht und eine Solarzellenanordnung, die Verkapselungsschicht umfassend eine Verkapselungszusammensetzung, umfassend eine Mischung aus einem Copolymer aus Ethylen und Vinylacetat (EVA) und einem Copolymer A mit verbesserter Anti-Potentialinduzierte-Degradations-Wirkung (PID),
**dadurch gekennzeichnet, dass** die Verkapselungszusammensetzung eine Leistungsabgabestabilität über > 90 % der anfänglichen Leistungsabgabe nach einer Exposition gegenüber feuchter Wärme (85 °C/85 % RH) und Spannungspotential von 1500 V für bis zu 96 Stunden bereitstellt,
wobei das Copolymer A ein E/X-Copolymer ist, wobei E Ethylen ist und X Halbester von Maleinsäureanhydrid ist und das E/X-Copolymer Maleinsäureanhydrid-Monomethylester, Maleinsäureanhydrid-Monoethylester (MAME), Maleinsäureanhydrid-Monopropylester, Maleinsäureanhydrid-Monobutylester oder eine Kombination dieser in dem Bereich von 12 bis 25 Gew.-% des Polymergewichts enthält;
oder wobei das Copolymer A ein E/X/Y-Copolymer ist, wobei E Ethylen ist und X Halbester von Maleinsäureanhydrid ist und X Maleinsäureanhydrid-Monomethylester, Maleinsäureanhydrid-Monoethylester (MAME), Maleinsäureanhydrid-Monopropylester, Maleinsäureanhydrid-Monobutylester oder eine Kombination dieser in dem Bereich von 6 bis 20 Gew.-% des Polymergewichts ist; und Y Methylacrylat, Ethylacrylat, n-Butylacrylat oder isoButylacrylat oder ein Gemisch dieser in dem Bereich von 1 bis 30 Gew.-% des Polymergewichts ist.

2. Fotovoltaikmodul nach Anspruch 1, wobei das Copolymer A in dem Bereich von 1-30 Gew.-% des Gesamtgewichts von EVA und Copolymer A, vorzugsweise in dem Bereich von 2-20 Gew.-% und am meisten bevorzugt in dem Bereich von 4-15 Gew.-%, ist.

3. Verfahren zum Reduzieren der potenzialinduzierten Degradation (PID) eines Fotovoltaikmoduls, das Verfahren umfassend die Schritte des Bereitstellens einer Solarzellenanordnung, einer Glasschicht und einer Verkapselungsschicht, umfassend die Verkapselungszusammensetzung nach Anspruch 1; Herstellen eines Fotovoltaikmoduls, umfassend die Strukturglasschicht/Verkapselungsschicht/Solarzellenanordnung; Betreiben des Fotovoltaikmoduls, und Beobachten des durch das Fotovoltaikmodul erzeugten Stroms in Abhängigkeit von einer Zeit.

4. Fotovoltaikmodul nach Anspruch 1, wobei die Verkapselungszusammensetzung in einem solchen Zustand gemäß der technischen Spezifikation IEC TS 62804-1 ein Spannungspotenzial von 1000 durchlässt.

5. Fotovoltaikmodul nach Anspruch 1, wobei die Verkapselungszusammensetzung in einem solchen Zustand gemäß der technischen Spezifikation IEC TS 62804-1 ein Spannungspotenzial von 1500 durchlässt.

6. Fotovoltaikmodul nach Anspruch 1, wobei das Copolymer der Verkapselungszusammensetzung ein copolymerisiertes Ethylen und Vinylacetat ist, wobei Vinylacetat in dem Bereich von 15 Gew.-% bis etwa 35 Gew.-% des Polymergewichts, am stärksten bevorzugt 25-32 Gew.-%, ist.

7. Fotovoltaikmodul nach Anspruch 1, wobei das Copolymer A das E/X-Copolymer ist.

8. Fotovoltaikmodul nach Anspruch 1, wobei das Copolymer A das E/X-Copolymer ist und X in dem Bereich von 15-20 Gew.-% des Polymergewichts vorhanden ist.

9. Fotovoltaikmodul nach Anspruch 1, wobei A das E/X/Y-Copolymer ist.

10. Fotovoltaikmodul nach Anspruch 1 das Copolymer A das E/X/Y-Copolymer ist und X in dem Bereich von 8-15 Gew.-% des Polymergewichts vorhanden ist; und wobei Y in dem Bereich von 5-15 Gew.-% des Polymergewichts vorhanden ist.

11. Fotovoltaikmodul nach Anspruch 1, wobei die Verkapselungszusammensetzung ein oder mehrere andere Polymere und oder andere Zusatzstoffe umfasst, vorausgesetzt, dass diese keine nachteilige Auswirkung auf die Performanz des Fotovoltaikmoduls hervorrufen.

12. Fotovoltaikmodul nach Anspruch 1, ferner umfassend eine oder mehrere Glasschichten, eine oder mehrere flexible Rückseitenschichten oder eine zweite Verkapselungsschicht, die gleich oder verschieden von der Verkapselungsschicht sein kann.

13. Fotovoltaikmodul nach Anspruch 1, das aus einer Struktur besteht, die aus der Gruppe ausgewählt ist, bestehend aus:
Glas/Verkapselung/Solarzellenanordnung/Verkapselungsschicht/Glas;
Glas/Verkapselung/Solarzellenanordnung/Verkapselung/flexible Rückseite;
Glas/Verkapselung/Solarzellenanordnung/Glas; und
Glas/Verkapselung/Solarzellenanordnung/flexible Rückseite.

14. Fotovoltaikmodul nach Anspruch 1, wobei die Solarzellenanordnung eine Dünnschichtsolarzelle umfasst.

15. Fotovoltaikmodul nach Anspruch 1, wobei die Verkapselungsschicht in einer mehrschichtigen Form vorliegt.

## Revendications

1. Module photovoltaïque comprenant une couche d'encapsulation et un ensemble de cellules solaires, ladite couche d'encapsulation comprenant une composition d'encapsulation, comprenant un mélange d'un copolymère d'acétate de vinyle-éthylène (EVA) et un copolymère A d'amélioration de la dégradation induite anti-potentielle (PID), **caractérisé en ce que** la composition d'encapsulation fournit une stabilité de sortie de puissance supérieure à >90 % de la sortie de puissance initiale après une exposition à la chaleur humide (85 °C/85 % RH) et un potentiel de tension de 1500 V pendant une durée de 96 heures maximum,
dans lequel le copolymère A est un copolymère E/X, dans lequel E est un éthylène et X est un demi-ester d'anhydride maléique et le copolymère E/X comporte un ester mono-méthylique d'anhydride maléique, un ester mono-éthylique d'anhydride maléique (MAME), un ester mono-propylique d'anhydride maléique, un ester mono-butylique d'anhydride maléique ou une combinaison de ceux-ci, dans la plage de 12 à 25 % en poids du poids de polymère ;
ou dans lequel le copolymère A est un copolymère E/X/Y, où E est un éthylène, X est un demi-ester d'anhydride maléique et X est un ester mono-méthylique d'anhydride maléique, un ester mono-éthylique d'anhydride maléique (MAME), un ester mono-propylique d'anhydride maléique, un ester mono-butylique d'anhydride maléique ou une combinaison de ceux-ci, dans la plage de 6 à 20 % en poids du poids de polymère, et Y est un acrylate de méthyle, acrylate d'éthyle, acrylate de n-butyle ou acrylate d'iso-butyle, ou un mélange de ceux-ci dans la plage de 1 à 30 % en poids du poids de polymère.

2. Module photovoltaïque selon la revendication 1, dans lequel le copolymère A est dans la plage de 1 à 30 % en poids du poids total d'EVA et du copolymère A, de préférence dans la plage de 2 à 20 % en poids, et le plus préférablement dans la plage de 4 à 15 % en poids.

3. Procédé de réduction de la dégradation induite anti-potentielle (PID) d'un module photovoltaïque, ledit procédé comprenant les étapes de fourniture d'un ensemble de cellules solaires, une couche de verre et une couche d'encapsulation comprenant la composition d'encapsulation selon la revendication 1 ; fabrication d'un module photovoltaïque comprenant la structure de couche de verre/couche d'encapsulation/ensemble de cellules solaires ; fonctionnement du module photovoltaïque ; et d'observation du courant généré par le module photovoltaïque en fonction du temps.

4. Module photovoltaïque selon la revendication 1, dans lequel la composition d'encapsulation procure un potentiel de tension de 1000 à une condition selon la spécification technique IEC TS 62804-1.

5. Module photovoltaïque selon la revendication 1, dans lequel la composition d'agent d'encapsulation procure un potentiel de tension de 1500 à une condition selon la spécification technique IEC TS 62804-1.

6. Module photovoltaïque selon la revendication 1, dans lequel le copolymère de la composition d'encapsulation est un acétate de vinyle-éthylène copolymérisé, où l'acétate de vinyle est dans la plage de 15 % en poids à environ 35 % en poids du poids de polymère, le plus préférablement 25 à 32 % en poids.

7. Module photovoltaïque selon la revendication 1, dans lequel le copolymère A est le copolymère E/X.

8. Module photovoltaïque selon la revendication 1, dans lequel le copolymère A est le copolymère E/X, et X est présent dans la plage de 15 à 20 % en poids du poids de polymère.

9. Module photovoltaïque selon la revendication 1, dans lequel le copolymère A est le copolymère E/X/Y.

10. Module photovoltaïque selon la revendication 1, dans lequel le copolymère A est le copolymère E/X/Y et X est présent dans la plage de y 8 à 15 % en poids du poids de polymère ; et dans lequel Y est présent dans la plage de 5 à 15 % en poids du poids de polymère.

11. Module photovoltaïque selon la revendication 1, dans lequel la composition d'encapsulation comprend un ou plusieurs autres polymères, et/ou d'autres additifs, à condition que ceux-ci ne n'entraînent pas un effet indésirable sur les performances du module photovoltaïque.

12. Module photovoltaïque selon la revendication 1, comprenant en outre une ou plusieurs couches de verre, une ou plusieurs couches de feuille arrière flexible, ou une seconde couche d'encapsulation qui peut être identique ou différente de la couche d'encapsulation.

13. Module photovoltaïque selon la revendication 1, constitué d'une structure sélectionnée à partir du groupe de : verre/agent d'encapsulation/ensemble de cellules solaires/couche d'encapsulation/verre ; verre/agent d'encapsulation/ensemble de cellules solaires/agent d'encapsulation/feuille arrière flexible ; verre/agent d'encapsulation/ensemble de cellules solaires/verre ; et verre/agent d'encapsulation/ensemble de cellules solaires/feuille arrière flexible.

14. Module photovoltaïque selon la revendication 1, dans lequel l'ensemble de cellules solaires comprend une cellule solaire à couche mince.

15. Module photovoltaïque selon la revendication 1, dans lequel la couche d'encapsulation est sous forme multicouche.
